# EUROPEAN PATENT SPECIFICATION

(11) **EP 1 846 776 B1**
(45) Date of publication and mention of the grant of the patent: **03.08.2011**
(21) Application number: 06709632.1
(22) Date of filing: 06.02.2006
(51) Int. Cl.: G01R 31/36, H02J 7/00, H01M 10/48

(54) **BATTERY MANAGEMENT SYSTEM**
BATTERIEMANAGEMENTSYSTEM
SYSTEME DE GESTION DE BATTERIE

(30) Priority: 04.02.2005 GB 0502274
(43) Date of publication of application: 24.10.2007
(73) Proprietor: Xipower Limited, Stirling FK7 9JQ (GB)
(72) Inventor: HUGGINS, Mark, Torphichen, West Lothian EH48 4NF (GB)
(74) Representative: Gordon, Naoise Padhraic Edward
(86) International application number: PCT/GB2006/000385
(87) International publication number: WO 2006/082425

(56) References cited:
- WO-A-00/42689
- WO-A-96/31933
- DE-A1- 19 756 744
- US-A- 5 982 143
- US-A- 6 016 047
- US-B1- 6 504 344

## Description

The present invention relates to battery management systems, to their implementation in Electronic Integrated Circuits, and more particularly to large scale integration techniques commonly known as System On Chip or System Level Integration.

In the field of battery management, it is highly desirable to monitor and/or control a number of parameters that affect battery performance. For example, a battery management system might include some of the following functionality:
State of Charge (SoC) measurement for determining the amount of remaining stored energy;
State of Health (SoH) measurement for determining the battery life expectancy;
Battery protection monitoring to ensure safe battery operation;
Charge Control for regulation of charging current and voltage; and
Cell Balancing to ensure maximum energy is stored and delivered without activating protection circuitry.

Presently many different electronic circuits are employed to provide the above described functionality. Current industry implementation makes use of up to seven integrated circuits to provide a total solution with only a few devices contained within the battery pack. Cell balancing, charger, and some data processing are housed within the host system.

Semiconductor manufacturers have developed specific electronic integrated circuits that provide one or more of these features in an attempt to reduce cost and minimise-solution size. Such examples of devices are Fuel Gauging IC's that provide SoC, Protection IC's that monitor the safe operation of the battery, Passive Cell Balancer IC's that ensure safe charging of multiple series connected battery cells, and Charger IC's that control the battery's charger unit. It therefore takes a number of integrated circuits and additional discrete circuitry to build a complete battery management system.

Problems that are not currently addressed are:
Accurate determination and compensation of battery self discharge current;
Compensation of SoC for battery operational temperature; Cell balancing during discharge;
Accurate SoH (State of Health) determination; and Application of battery management to large Cell stacks (greater than 8 series or parallel connected cells).

### Passive Cell Balancing

A single cell Li-Ion battery provides a nominal output voltage of around 3.7V and has a narrow range of safe operation of between 3V and 4.2V. Should the cell voltage drift outwith this safe zone, through over discharge or over charging, the Li-Ion cell will be irreparably damaged and under certain circumstances there is risk of catastrophic failure resulting in fire and or explosion.

An internal protection circuit as described earlier prevents the cell from being over charged or discharged.

In multi-cell battery packs, cells are connected in series to provide a greater output voltage for use in applications that require a greater energy capacity such as lap top computers and electric vehicles. Each cell has slightly different electrical characteristics due to variations in assembly and chemistry. The protection circuit must act on the lowest and/or highest cell voltage in the multi-cell pack. This means that battery packs can be disabled for just a single discharged cell, thus preventing further energy being released, or a single overcharged cell preventing full charge of the battery pack. This problem significantly reduces the available charge from a multi-cell battery.

The objective of cell balancing is to compensate for these variations in cell electrical characteristics such as impedance and capacity by ensuring that each 'series' connected cell operates with the same cell voltage and within an acceptable tolerance. Cell balancing maximises available charge in series connected multi-cell battery packs and increases life expectancy through reduction in charging cycles.

### Passive:

Passive cell balancing switches a resistor across a high voltage cell to remove charge from it and pass it onto the lower cell/cells. Another possible approach would be to use a shunt regulator across each cell this would remove the need for the resistor with all cell voltage being supported by the shunt pass transistor. Both methods have two problems; firstly they both dissipate energy, secondly their only use is during the charging cycle as it would lessen battery capacity and shorten life during discharge cycle due to the additional dissipation. Current Li-Ion battery management integrated circuits that incorporate cell balancing utilise the passive approach examples being Xicor's X310 series and Texas Instruments bq29311.

It is an object of the present invention to provide a complete battery management system. It is a further object of the invention to implement the battery management system on a single Application Specific Integrated Circuit or by using several integrated circuits with or without further discrete circuitry.

In accordance with a first aspect of the present invention there is provided a battery pack containing: a battery; and a battery management system comprising one or more battery monitoring means and programmable logic; wherein the programmable logic is connected to the one or more battery monitoring means to modify its battery operation and report battery status; and the battery management system is embedded in the battery pack, with the battery; characterised in that the battery monitoring means comprises active cell balancing control means associated with each battery cell and operable to enable the transfer of energy from strong cells to weak cells during both the charging and discharging cycles, and wherein the active cell balancing control means is operable as an integral charger.

Preferably, the battery monitoring means reports battery status through a communication bus to an external host.

Implementation is applicable to all electrical energy storage systems that comprise series or parallel connected electro chemical storage elements. This includes but is not limited to Super or Ultra Capacitor's, fuel cells, NiMH, NiCd, Pb & Lithium Chemistry battery packs.

Implementation of programmable logic enables the invention to be configured for a variety of battery chemistries.

Preferably, the battery monitoring means is provided with data acquisition means to record battery performance parameters.

Preferably, the programmable logic is configured to analyse data received from the one or more battery monitoring means and to modify the operation of the battery in response to said data.

Preferably, data acquisition means is placed across each cell of the battery to collect data from said cell.

Optionally, a data acquisition device is configured to collect data from a plurality of cells.

Preferably, the programmable logic is configured to analyse physical data.

Preferably, the programmable logic is configured to analyse physical data relating to the effect of temperature on battery capacity and/or the effect of temperature on battery self discharge current.

Preferably, the programmable logic is configured to derive the actual state of charge at any operational temperature.

Preferably, the programmable logic contains one or more look-up tables and/or algorithms.

Preferably, the programmable logic comprises a digital microprocessor and digital memory.

Preferably, the programmable logic comprises a digital means of communication with internal and external systems and the ability to report battery status and provide external control of a battery.

Preferably, the programmable logic is embedded in the battery management system.

Preferably, the battery monitoring means comprises state of charge measurement means.

Preferably, the battery monitoring means comprises state of health measurement means.

Preferably, the battery monitoring means comprises battery protection means.

Preferably, the battery protection means comprises switching means to control current flow from a power source.

Preferably, the battery monitoring means comprises charging control means.

Preferably, the active cell balancing control comprises a switched mode converter, attachable to a primary energy source and capable of moving energy from the primary energy source to one or more cells depending upon the respective energy requirements of the cells. The primary energy source can be a battery or an external power supply.

Preferably, the programmable logic is adapted to operate temperature control means.

Preferably, the temperature control means comprises heating means to warm the cells.

The primary energy source can be external to the battery pack in charge mode.

Preferably, the primary energy source can be derived from the battery pack in active cell balancing mode

Preferably, the active cell balancing circuitry can operate as a sulphation removal system when used in a Pb (lead acid) battery stack.

This is a result of the ability of the active cell balancing circuitry to deliver current pulses.

A Flyback topology can be used as a switched mode converter.

The type of switched mode converter is not limited to flyback and can comprise other converter topologies.

The use of a Flyback Switched Mode Converter in both discontinuous and continuous mode is an effective energy transfer device for cell balancing and cell charging as all outputs track.

Preferably, the Flyback Switched mode converter is provided with one or more synchronous output or secondary rectifiers.

The use of synchronous rectifiers improves energy conversion efficiency and can better steer energy to the appropriate weak cell.

Optionally, the Flyback switched mode converter is provided with one or more output or secondary rectifier diodes.

Preferably, a switched magnetic or capacitive converter may be configured to actively transfer energy from strong cells to weak cells within the battery pack.

Preferably, the battery management system is provided with self discharge current measurement means.

Preferably, the self discharge measurement means comprises a current oscillator which can be coupled to a battery when the battery is in sleep mode, the current oscillator having a temperature coefficient that corresponds to the temperature coefficient of the battery.

Preferably the battery management system is provided with means for disabling the battery during transit, said means being provided as an instruction from the programmable logic.

In accordance with a second aspect of the invention there is provided a battery management system of the first aspect of the invention incorporated in an application specific integrated circuit.

In accordance with a third aspect of the invention there is provided a battery management system of the first aspect of the invention incorporated in a discrete printed circuit board.

Preferably, application to a large cell stack can be implemented through modules that comprise individual DC/DC converters, all monitoring, communication and logic functions. Each cell in the stack is connected to its own individual cell module.

The present invention will now be described by way of example only, with reference to the accompanying drawings in which:
Figure 1 is a schematic diagram of an example of the present invention;
Figure 2 is a circuit block diagram of a first embodiment of a battery management system in accordance with the present invention;
Figure 3 is circuit block diagram of a switched mode converter used in a second embodiment of the present invention;
Figure 4 is a circuit block diagram of a data acquisition device suitable for use in an embodiment of the present invention;
Figure 5 is a circuit block diagram of a data acquisition device suitable for use in an embodiment of the present invention;
Figure 6 is a circuit block diagram of a second embodiment of the present invention;
Figure 7 is a circuit block diagram of a digital processor and controller for use in an embodiment of the present invention with a large number of series connected cells;
Figure 8 is a circuit block diagram showing the configuration of modules described in figure 6 where the circuit is in charge mode;
Figure 9 is the circuit block diagram of figure 8 in discharge mode; and
Figure 10 is the circuit block diagram of figure 8 implemented with a constant voltage charger.

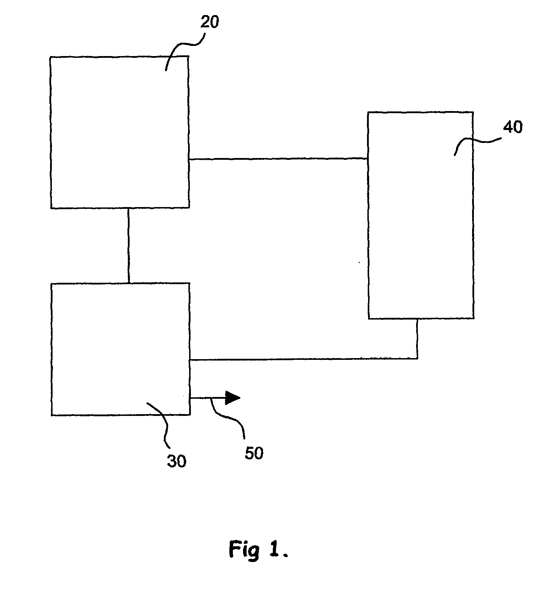

As shown in Figure 1, the present invention incorporates battery monitoring means 20 such as active cell balancing control and status reporting, SoC measurement and reporting, SoH measurement and reporting, Protection control and status reporting, Charging control and reporting.

These battery monitoring means are programmable through the implementation of programmable logic 30 as an embedded digital microprocessor and digital memory. The battery management system is able to communicate so with an external host through the implementation of a serial or parallel wired bus or through a wireless communication link. The programmable logic is also able to communicate with the battery 40.

Implementation of a digital microprocessor and digital memory enables the present invention to be configured for multiple battery chemistries. In addition, the digital microprocessor and digital memory enables processing of captured data to compensate for a wide variety of physical processes not currently considered in the state of the art. In particular algorithms or look up tables can be used to compensate for the effect of temperature on battery capacity and for the effect of temperature on battery self discharge current. Algorithms are also used to establish cell aging from variation in complex cell impedance coupled with depth of discharge history. The complex and static impedance being derived from the measurements made by the data acquisition modules.

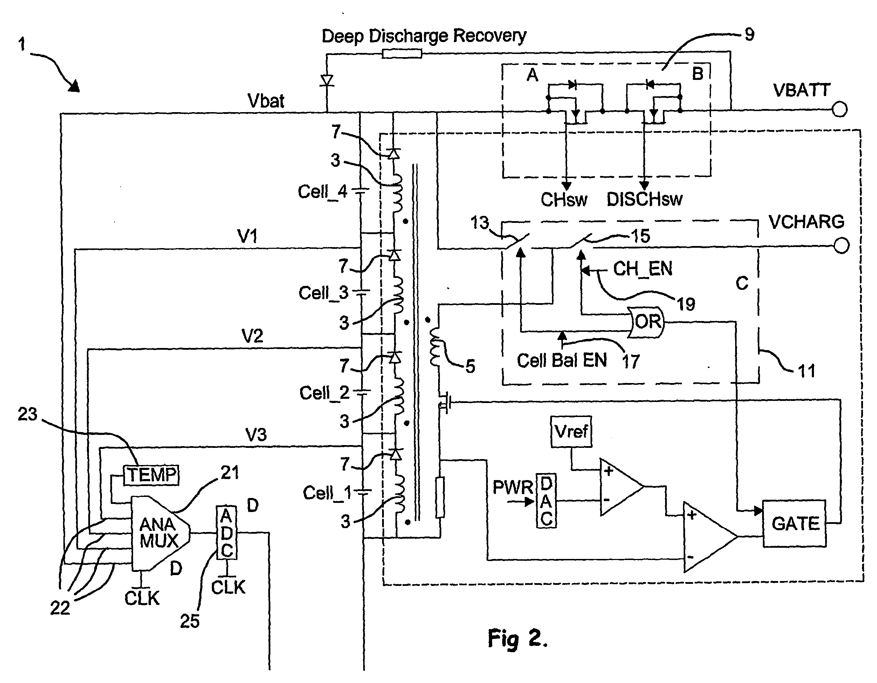

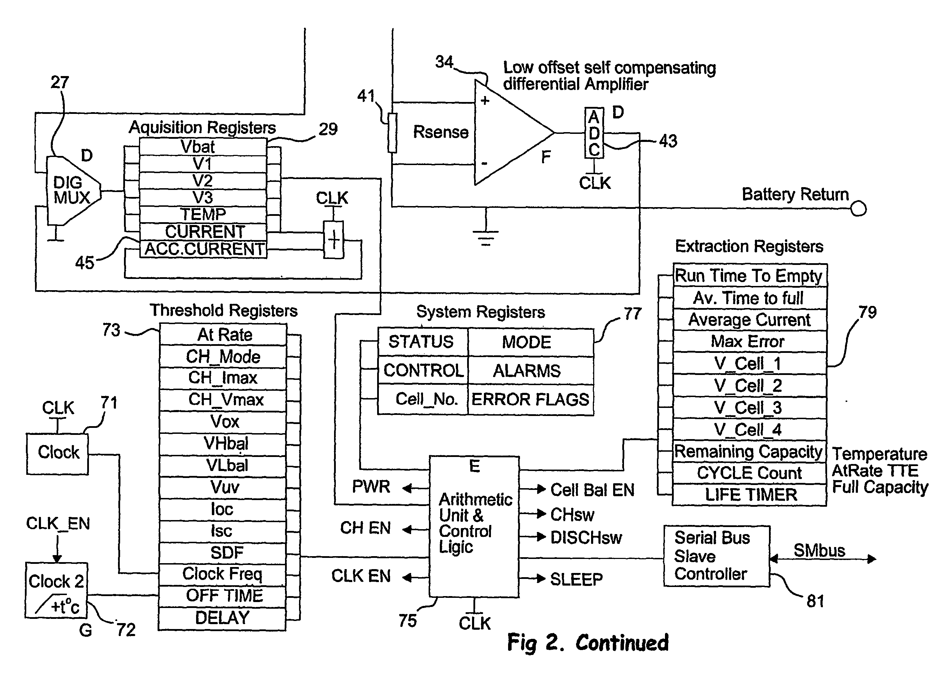

An example of the present invention is shown in Figure 2.

The implementation.of a Flyback Switched mode power supply either operating in the discontinuous or continuous mode offers a source of charge current for each series connected cell within the battery. Multiple secondary windings on a single coupled inductor 5 enable the sharing of energy that is delivered to the coupled inductor through the primary inductor winding 5. The primary energy source can be from an external charge source or if connected to the battery output from the battery itself.

Implementation can also comprise individual switch mode power supply converters without coupled secondary windings.

When connected to the battery output the circuit is configured for Active Cell Balancing. In this mode energy is taken from the battery pack and delivered to the weakest (lowest charge state) cell effectively transferring energy from higher capacity cells into lower capacity cells to enable the maximum energy to be withdrawn from the battery pack. Without Active Cell Balancing the battery's protection circuit would turn off the battery output when the lowest charged cell was depleted even though energy remained in higher capacity cells.

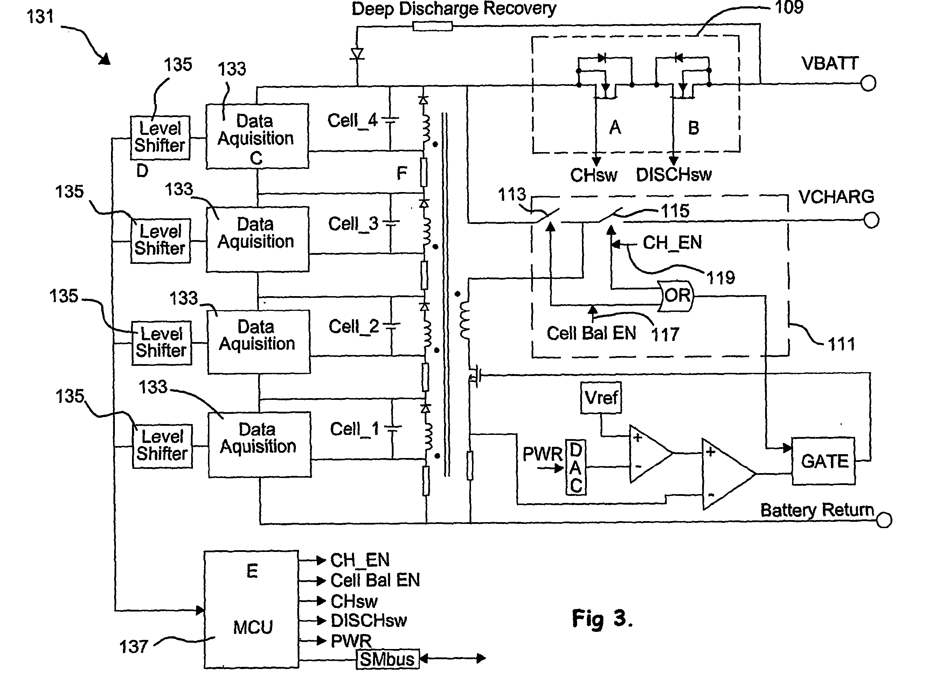

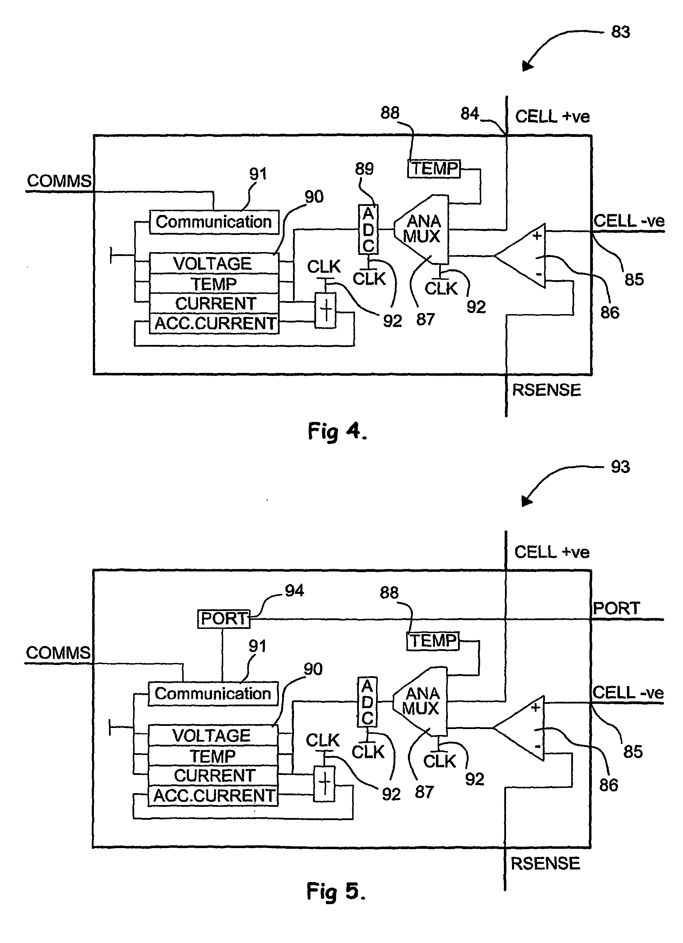

An enhancement of the Active Cell Balancer circuit shown as a Flyback switched mode power supply in figure 1 is to place individual data acquisition devices across each cell as shown in figure 3. This enables greater accuracy of capacity determination in accommodating energy lost through cell balancing. It is to be noted that Active Cell balancing provides greater accuracy due to its significantly higher efficiency than Passive Cell balancing. This configuration can also report individual cell absolute and relative capacities as they age so providing useful service information. Typical data acquisition devices are shown in figures 4 and 5.

The data acquisition device 83 of figure 4 comprises inputs from a cell 84, 85 a low offset compensating differential amplifier 86 connected to an analogue multiplexer 87 which also has a temperature sensor 88 connected to its input. The analogue to digital converter 89 provides the input to register 90 and communications means 91. A synchronising clock input 92 is also provided.

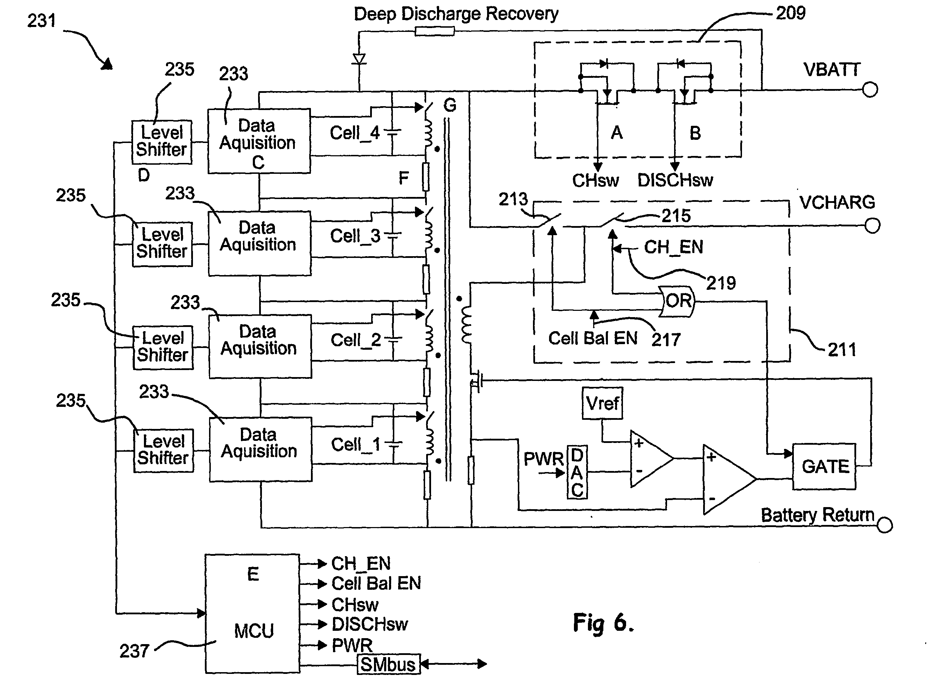

An additional enhancement to the Active Cell Balancer shown as a Flyback converter in figures 2 and 3 is to replace all output diodes with synchronous rectifiers (figure 6). In this embodiment the microprocessor can select which synchronous rectifier to activate in order to better steer energy into the weakest cell without energy escaping into higher charged cells which reduces overall efficiency. In this embodiment the data acquisition device 93 has, in addition to those features shown in figure 4, a control port 94 that activates the synchronous rectifier (figure 5).

A four cell battery management system incorporating active cell balancing is described in figure 2, 3 and 6.

The system contains six functional blocks

The battery protection block that protects the battery from excessive charge and discharge.

The charger block that replenishes charge once the battery is discharged.

The data acquisition block that acquires state of battery (voltage, current, temperature, capacity) information.

The coulomb counter block that accurately determining the available capacity of the battery (fuel gauge).

The digital processor and digital bus communication block that processes data and hosts communications.

The Cell Balancing used to maximise the available charge in series connected multi-cells.

The Active Cell Balancing unit can be configured to act as the charger thereby eliminating the need for an additional charger circuit.

### Battery Protection

Referring to figure 2 battery protection 9 is afforded through two power switches referenced A and B. These two switches are controlled by logic that operate each switch depending on the operating condition sensed by the data acquisition circuitry. The two switches enable either full charge/discharge (two way current flow), charge only (one way current flow into battery), discharge only (one way current flow out of the battery) and finally in a fault condition both switches are off enabling no current to flow into or out of the battery.

It is to be noted that Li-Ion batteries have a very narrow window of safe operation and if subject to operating conditions outwith this window extensive damage can result to the Li-Ion cell/battery and in extreme situations there is risk of excessive heat/explosion. Battery protection is therefore for Li-Ion cells/batteries.

The conditional state of protection circuitry and operating mode can be relayed to the host system by the digital bus communication link between battery pack and host system.

### Battery Charger

Referring to figure 2 the battery charger 11 is represented by the block identified as reference C. The purpose of the charger block is to replenish the battery charge from a variety of power sources such as a mains outlet block, or vehicle 12V/24V socket. The charger block is under control of the internal data processor and the host system controller via the digital bus communication link between battery pack and host system.

The Charger block is function performed by the Active Cell Balancer block. Two switches controlled by CH_EN 19 and CellBalEN 17 select which mode is appropriate. The two switches are never on at the same time.

The charger can operate in a number of modes accommodating a variety of different battery cell chemistries. These modes include constant current followed by constant voltage and float charging. A detailed description of operation now follows:-

### Data Acquisition

The purpose of the data acquisition circuitry is to provide measurements of all the batteries vital performance parameters such as cell voltage, current flow and temperature. These parameters are analogue so they need to be sensed (21, 22) and then converted into digital signals 25 before being handed over to the digital processor. Two 12 bit Analogue to Digital Converters 25, ADC's, are used. The inputs 22 to the ADC's are multiplexed 21 to save on operating current and circuit area. One analogue multiplexer 21 and one digital multiplexer 27 are used. An acquisition register 29 is provided to hold the acquired data for further processing. All this circuitry is represented by the reference D in figure 2.

The analogue and digital multiplexers are programmable to accommodate different numbers of series connected cells.

The embodiment described in figure 3 and 6 show each cell having its own data acquisition device (133,233,135,235) each reporting to the main micro controller through a common serial communication bus. This improves the accuracy of data collected specific to each individual cell.

### Coulomb Counter

To accurately determine available capacity of battery (fuel gauge) the current into and out of the battery is sensed and integrated (accumulated). The charge is counted going into the battery and the charge is counted leaving the battery the difference between the two counts is the estimated remaining battery capacity. An ultra low offset self compensating differential amplifier 34, figure 2 reference F, senses the voltage across the current sense resistor 41. The maximum voltage corresponding to maximum current will be around +/-100mV. The output of the differential amplifier is then converted to a digital value by an ADC and placed in the acquisition register for later processing by the arithmetic unit and accumulated current register. Current is integrated by the cumulative addition of sampled current in the ACC. CURRENT register 45. The output of the current ADC is signed in 2's complement to enable subtraction for discharge.

In the embodiment described by figures 3 and 6 each cell has its own Coulomb Counter to improve accuracy of measurement and provide additional state of health information.

### Digital Processor and Digital Bus communication

A digital signal processor is required to control system operation, collate acquired data, process data, communicate data with host system, and accept system control commands from host system via the communication digital bus.

The digital processor and digital bus communication functionality of figure 2 provide the programmable logic functions which operate upon the data acquired relating to cell performance. A clock 71 and clock enable 72 are provided along with a threshold register which contains threshold valves of many of the measurable physical parameters of a cell such as Ch_Imax (Charge Current Maximum). The arithmetic unit and control logic 75 is programmable in a manner selected by the user depending upon for instance the physicial properties of the cells in the battery.

System register 77 which controls status and mode of the system as well as an extraction register 79 and communications (bus 81) are also shown.

The programmable logic is programmed to optimise battery performance in response to changes in battery performance identified through acquired data.

### Active Cell Balancing

The present invention uses active cell balancing. Active cell balancing makes use of switching capacitors or magnetic circuits to balance each cell voltage. The active approach can be applied in both the charge and discharge cycle furthermore the efficiency of conversion is greatly increased. There are potentially many different types of active cell balancing circuits, some of the simplest make use of capacitors that are switched across each cell in rotation. The capacitors transfer charge to and from each cell to balance their respective voltages. As a consequence of the size of capacitors and switching frequency required this configuration works best for low capacity batteries.

Other possible active cell balancing schemes can make use of magnetic switching circuits such as the Buck and Flyback topologies. The Flyback approach is simple to implement and has the inherent ability to distribute energy without the need for any complex control circuitry. However, the design of the Coupled Inductor is important because all leakage inductances must balance within limits to enable accurate charge distribution.

Given the application tolerances for Li-Ion the Flyback approach has been adopted in the embodiment of the invention shown in figures 2 and 3 and 6.

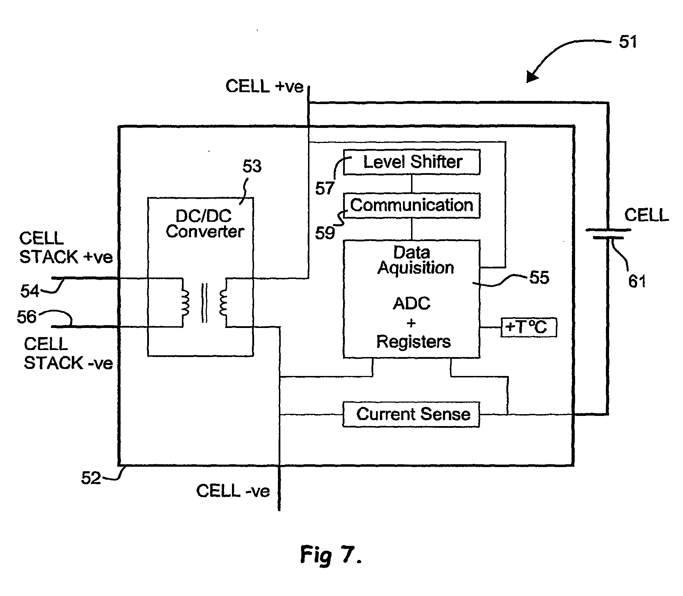

Figure 2 shows a four cell system. However, the digital processor and controller can be made flexible to accommodate a defined maximum number of cells. The cell number register can be written to via the serial bus to define the number of cells for any given application. This data register is then used by the controller to configure all Analogue and Digital multiplexers and data registers to control a specific number of cells for that programmed application. Though the maximum number of series connected cells is envisaged to be no more than eight in this embodiment. For application to a greater number of series connected cells the embodiment described by figures 7 and 8 and 10 would enable systems to be built that would support application to heavy industrial devices such as electric vehicles and standby battery banks that generally require terminal voltages exceeding 300V.

The cell balancing circuit activation can be enabled outside of two programmable thresholds VHbal and VLbal. This will prevent the cell balancing circuitry being active during most operating conditions and hence save on battery life. Only when any cell voltage is higher than the VHbal or lower than the VLbal thresholds will the cell balancing circuitry be active.

**Accurate self discharge estimate**: When the battery is lying idle with no current being drawn from it there exists a low internal self discharge current that changes with cell temperature and cell voltage. If the appliance is switched off for an extended period of time the indicated remaining capacity will be in error due to the extended period of self discharge. The present invention provides a means of estimating the self discharge current during power down and thus provides a far more accurate indication of remaining capacity when the appliance is turned on after an extended power off period.

The present invention uses an ultra low current oscillator (reference G), that operates when the battery is in sleep mode. The oscillator has a strong temperature coefficient that corresponds with that of the battery self discharge temperature profile. The count obtained from the sleep counter is processed with the capacity register on recovery from sleep mode to provide an accurate estimate of remaining capacity.

The ultra low current oscillator prevents further drain on battery during sleep mode and to match the temperature coefficient to that of the battery cell discharge profile.

Safe Transportation and Storage: Use of internal protection circuit to disable battery pack when in transportation, storage or host demand. The digital serial bus enables commands to be sent to the battery management system controller to disable the battery on demand.

**Temperature variation of State of Charge:** This effect is particularly acute for Lithium based cell chemistries. The available capacity from a cell can significantly reduce as temperature falls. The full capacity is restored upon temperature recovery. The implementation of an embedded digital microprocessor and digital memory enables acquired capacity data to be processed using look up tables or algorithms to compensate for this temperature affect.

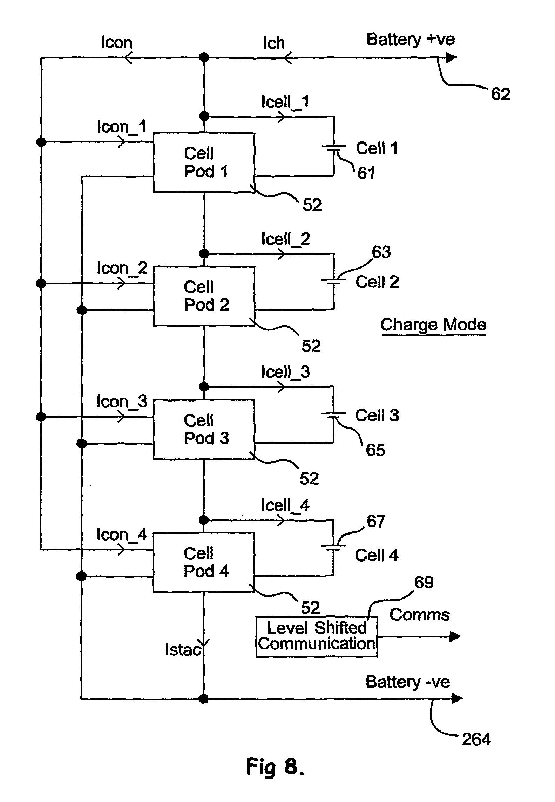

Figure 8 shows the configuration of modules 52 described in figure 7 to implement a full active cell balancing system for a stack of four cells (61,63,65,67). The modular construction permits as many series connected cells as the rated isolation voltage of the DC/DC converter and communication system can tolerate. Figure 8 shows a battery system being supplied by a Constant Current Constant Voltage (CCCV) charger connected across Battery +ve and Battery -ve terminals. At the start of the charge cycle a constant current, Ich, is supplied to the cell stack. Current is diverted away from the cell stack, Istac, by CELL Pod DC/DC converters, Icon, to support cells that have lower voltages. This reduces the rate at which higher voltage cells charge and increases the rate at which lower voltage cells charge. It is through this mechanism that each cell voltage may be balanced during the charge cycle. This implementation relies on their being a constant current charge source which is valid for Lithium Ion and many other cell chemistries.

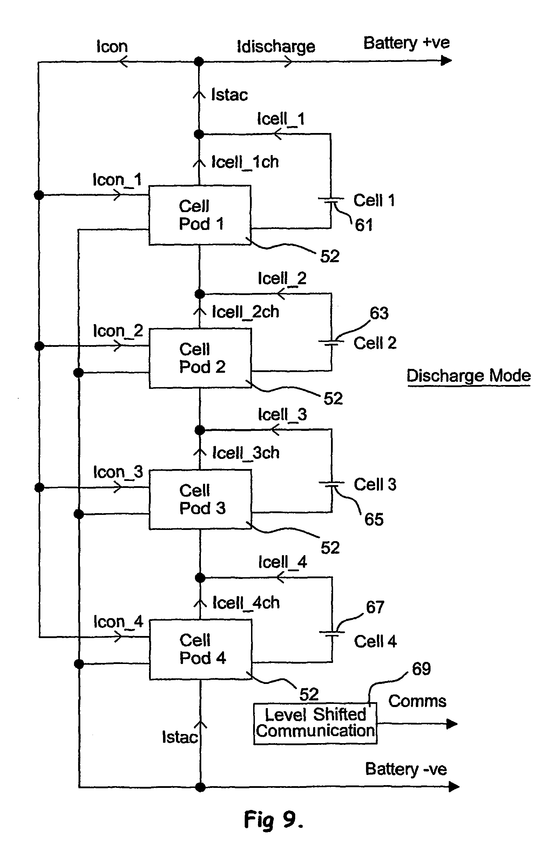

In the discharge cycle as shown in figure 9 current is taken from the cell stack by DC/DC converter/converters to boost the cell voltage/voltages of cells that have a lower voltage. In this embodiment Istac>=Idischarge (Istack=Icon+Idischarge) though individual cells of low voltage will have significantly lower current than Istack with the DC/DC converter supporting Istack though bypassing each low voltage cell. For low voltage cells Icell_x<Istack with Icell_xch+Icell=Istack.

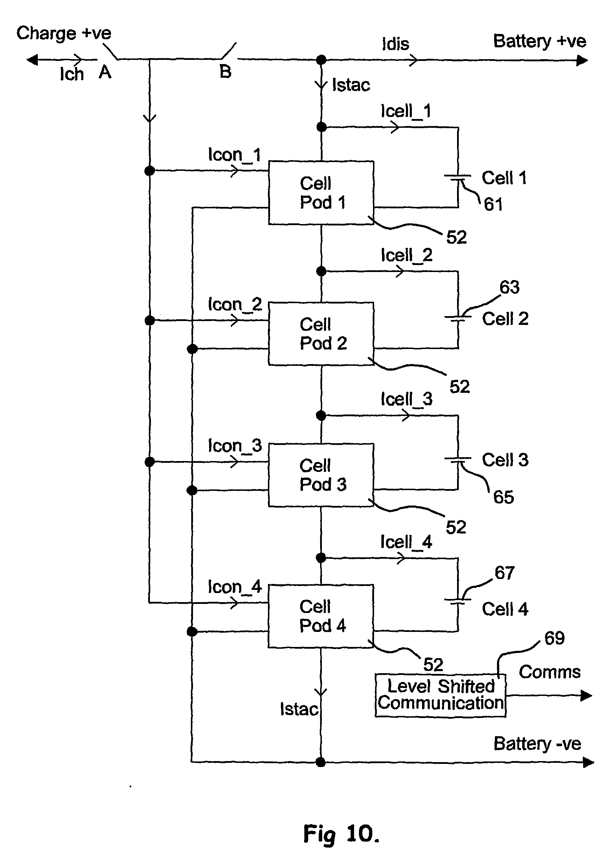

Figure 10 shows implementation to constant voltage chargers as used with Lead Acid cell technology. In this embodiment all charge current is passed through the cell DC/DC converters. Each cell converter has direct control over its connected cell charge rate and so can regulate its cell voltage at an appropriate level during charge cycle. When in discharge mode the DC/DC converters are all connected to the cell stack and cell balancing works in exactly the same way as above Lithium Ion implementation. Switch A is closed and switch B is open during charge mode. In discharge mode Switch A is open and Switch B is closed.

In an alternative embodiment the programmable logic can be programmed to operate internal heaters to warm the cells to enable additional energy release. The heaters deriving their power from the battery pack. This technique enables maximum energy to be released from the battery pack at low temperatures. The heaters may also operate in charge mode to increase charge acceptance of the battery pack thus enabling maximum energy storage. The programmable logic algorithms compensate for charge acceptance and charge release with cell temperature to allow accurate tracking of cell capacity.

In one preferred embodiment of the invention, Protection, SoC, SoH, Active Cell Balance Control, Charger Control, Communication Bus, Microprocessor, and Memory monitoring means are integrated onto a single Application Specific Integrated Circuit using CMOS, BiCMOS or BIPOLAR semiconductor process. All electronic power circuitry would be external to the Application Specific Integrated Circuit.

In addition all power electronic circuitry can be integrated onto the substrate as control, monitoring, acquisition, processing and communication.

Other embodiments make use of several integrated circuits and additional electronic circuitry.

The present invention allows the integration of all the above functional blocks onto a single integrated circuit in a way that will serve a wide application base. This single integrated circuit can then be embedded into the battery pack to remove all battery management from the host system and in doing so reduce manufacturing cost, increase battery capacity, increase battery life, and increase system reliability.

Improvements and modifications may be incorporated herein without deviating from the scope of the invention.

## Claims

1. A battery pack containing:
a battery; and
a battery management system comprising one or more battery monitoring means and
programmable logic;
wherein the programmable logic is connected to the one or more battery monitoring means to modify its battery operation and report battery status; and the battery management system is embedded in the battery pack, with the battery;
**characterised in that** the battery monitoring means comprises active cell balancing control means associated with each battery cell and operable to enable the transfer of energy from strong cells to weak cells during both the charging and discharging cycles, and wherein the active cell balancing control means is operable as an integral charger.

2. A battery pack as claimed in claim 1, wherein the battery monitoring means reports battery status through a communication bus to an external host.

3. A battery pack as claimed in claim 1 or 2, wherein the battery monitoring means is provided with data acquisition means to record battery performance.

4. A battery pack as claimed in any preceding claim, wherein the programmable logic is configured to analyse data received from the one or more battery monitoring means and to modify the operation of the battery in response to said data.

5. A battery pack as claimed in claim 3, wherein the data acquisition means is placed across each cell of the battery to collect data from said cell.

6. A battery pack as claimed in claim 3 or claim 5, wherein the data acquisition means is configured to collect data from a plurality of cells.

7. A battery pack as claimed in any preceding claim, wherein the programmable logic is configured to analyse physical data.

8. A battery pack as claimed in any preceding claim wherein, the programmable logic is configured to analyse physical data relating to the effect of temperature on battery capacity and/or the effect of temperature on battery self discharge current.

9. A battery pack as claimed in any preceding claim wherein, the programmable logic is conjured to derive the actual state of charge at any operational temperature.

10. A battery pack as claimed in any preceding claim wherein, the programmable logic contains one or more look-up tables and/or algorithms.

11. A battery pack as claimed in any preceding claim wherein, the programmable logic comprises a digital microprocessor and digital memory.

12. A battery pack as claimed in any preceding claim wherein, the programmable logic comprises a digital means of communication with internal and external systems and the ability to report battery status and provide external control of a battery,

13. A battery pack as claimed in any preceding claim wherein, the programmable logic is embedded in the battery management system.

14. A battery pack as claimed in any preceding claim wherein, the battery monitoring means comprises state of charge measurement means.

15. A battery pack as claimed in any preceding claim wherein, the battery monitoring means comprises state of health measurement means.

16. A battery pack as claimed in any preceding claim wherein, the battery monitoring means comprises battery protection means.

17. A battery pack as claimed in any preceding claim wherein, the battery protection means comprises switching means to control current flow from a power source.

18. A battery pack as claimed in any preceding claim wherein, the battery monitoring means comprises charging control means.

19. A battery pack as claimed in claim 1 wherein, the active cell balancing control comprises a switched mode converter, attachable to a primary energy source and capable of moving energy from the primary energy source to one or more cells depending upon the respective energy requirements of the cells.

20. A battery pack as claimed in any preceding claim, wherein the programmable logic is adapted to operate temperature control means.

21. A battery pack as claimed in claim 20, wherein the temperature control means comprises heating means to warm the cells.

22. A battery pack as claimed in claim 19, wherein the active cell balancing means operates as a sulphation removal system when used in a Pb (lead acid) battery stack.

23. A battery pack as claimed in claim 19, wherein a Flyback topology can be used as a switched mode converter.

24. A battery pack as claimed in claim 23, wherein the Flyback switched mode converter is provided with one or more synchronous output or secondary rectifiers.

25. A battery pack as claimed in claim 23 or claim 24, wherein the Flyback switched mode converter is provided with one or more output, or secondary rectifier diodes.

26. A battery pack as claimed in any preceding claim, wherein a switched magnetic or capacitive converter may be configured to actively transfer energy from strong cells to weak cells within the battery pack.

27. A battery pack as claimed in any preceding claim, wherein the battery management system is provided with self discharge current measurement means.

28. A battery pack as claimed in claim 27, wherein the self discharge measurement means comprises a current oscillator which can be coupled to a battery when the battery is in sleep mode, the current oscillator having a temperature coefficient that corresponds to the temperature coefficient of the battery.

29. A battery pack as claimed in any preceding clam wherein the battery management system is provided with means for disabling the battery during transit, said means being provided as an instruction from the programmable logic.

30. A battery pack as claimed in any preceding claim, wherein the battery management system is incorporated in an application specific integrated circuit.

31. A battery pack as claimed in any of the preceding claims, wherein the battery management system is incorporated in a discrete printed circuit board.

## Patentansprüche

1. Batteriesatz, enthaltend:
eine Batterie; und
ein Batteriemanagementsystem, das eine oder mehrere Batterieüberwachungseinrichtungen sowie programmierbare Logik umfasst;
wobei die programmierbare Logik mit der einen oder den mehreren Batterieüberwachungseinrichtungen verbunden ist, um den Batteriebetrieb zu modifizieren und den Batteriestatus zu melden, und das Batteriemanagementsystem zusammen mit der Batterie in den Batteriesatz eingebettet ist,
**dadurch gekennzeichnet, dass** die Batterieüberwachungseinrichtung eine Einrichtung zur aktiven Zellsymmetrierungssteuerung umfasst, die jeder Batteriezelle zugeordnet ist und betrieben werden kann, um die Energieübertragung von starken Zellen zu schwachen Zellen während sowohl der Lade- als auch der Entladezyklen zu ermöglichen, und wobei die Einrichtung zur aktiven Zellsymmetrierungssteuerung als integrierte Ladevorrichtung betrieben werden kann.

2. Batteriesatz gemäß Anspruch 1, wobei die Batterieüberwachungseinrichtung den Batteriestatus über einen Kommunikationsbus an einen externen Host meldet.

3. Batteriesatz gemäß Anspruch 1 oder 2, wobei die Batterieüberwachungseinrichtung über eine Datenerfassungseinrichtung zur Aufzeichnung der Batterieleistung verfügt.

4. Batteriesatz gemäß einem der vorherigen Ansprüche, wobei die programmierbare Logik dazu konfiguriert ist, die von der einen oder den mehreren Batterieüberwachungseinrichtungen empfangenen Daten zu analysieren und den Betrieb der Batterie als Reaktion auf diese Daten zu modifizieren.

5. Batteriesatz gemäß Anspruch 3, wobei die Datenerfassungseinrichtung an jeder Zelle der Batterie platziert ist, um Daten von der Zelle zu sammeln.

6. Batteriesatz gemäß Anspruch 3 oder Anspruch 5, wobei die Datenerfassungseinrichtung dazu konfiguriert ist, Daten von einer Mehrzahl von Zellen zu sammeln.

7. Batteriesatz gemäß einem der vorherigen Ansprüche, wobei die programmierbare Logik dazu konfiguriert ist, physische Daten zu analysieren.

8. Batteriesatz gemäß einem der vorherigen Ansprüche, wobei die programmierbare Logik dazu konfiguriert ist, physische Daten in Bezug auf die Auswirkung der Temperatur auf die Batteriekapazität und/oder auf die Auswirkung der Temperatur auf den Selbstentladestrom der Batterie zu analysieren.

9. Batteriesatz gemäß einem der vorherigen Ansprüche, wobei die programmierbare Logik dazu konfiguriert ist, den tatsächlichen Ladezustand bei jeder Betriebstemperatur abzuleiten.

10. Batteriesatz gemäß einem der vorherigen Ansprüche, wobei die programmierbare Logik eine oder mehrere Nachschlagetabellen und/oder -algorithmen enthält.

11. Batteriesatz gemäß einem der vorherigen Ansprüche, wobei die programmierbare Logik einen digitalen Mikroprozessor und einen digitalen Speicher umfasst.

12. Batteriesatz gemäß einem der vorherigen Ansprüche, wobei die programmierbare Logik eine digitale Einrichtung zur Kommunikation mit internen und externen Systemen umfasst, die in der Lage ist, den Batteriestatus zu melden und für die externe Steuerung einer Batterie zu sorgen.

13. Batteriesatz gemäß einem der vorherigen Ansprüche, wobei die programmierbare Logik in das Batteriemanagementsystem eingebettet ist.

14. Batteriesatz gemäß einem der vorherigen Ansprüche, wobei die Batterieüberwachungseinrichtung eine Einrichtung zum Messen des Ladezustands umfasst.

15. Batteriesatz gemäß einem der vorherigen Ansprüche, wobei die Batterieüberwachungseinrichtung eine Einrichtung zum Messen des Gesundheitszustands umfasst.

16. Batteriesatz gemäß einem der vorherigen Ansprüche, wobei die Batterieüberwachungseinrichtung eine Batterieschutzeinrichtung umfasst.

17. Batteriesatz gemäß einem der vorherigen Ansprüche, wobei die Batterieschutzeinrichtung eine Schalteinrichtung zur Steuerung des Stromflusses von einer Stromquelle umfasst.

18. Batteriesatz gemäß einem der vorherigen Ansprüche, wobei die Batterieüberwachungseinrichtung eine Ladesteuerungseinrichtung umfasst.

19. Batteriesatz gemäß Anspruch 1, wobei die aktive Zellsymmetrierungssteuerung einen getakteten Wandler umfasst, der mit einer primären Energiequelle verbunden werden kann und in der Lage ist, in Abhängigkeit von den jeweiligen Energieanforderungen der Zellen Energie von der primären Energiequelle zu einer oder mehreren Zellen zu übertragen.

20. Batteriesatz gemäß einem der vorherigen Ansprüche, wobei die programmierbare Logik dazu eingerichtet ist, eine Temperatursteuereinrichtung zu betreiben.

21. Batteriesatz gemäß Anspruch 20, wobei die Temperatursteuereinrichtung eine Heizeinrichtung zum Aufwärmen der Zellen umfasst.

22. Batteriesatz gemäß Anspruch 19, wobei die Einrichtung zur aktiven Zellsymmetrierung als Sulfatierungsentfernungssystem betrieben wird, wenn sie in einem Pb-(Blei)-Batteriestapel eingesetzt wird.

23. Batteriesatz gemäß Anspruch 19, wobei als getakteter Wandler eine Sperrtopologie verwendet werden kann.

24. Batteriesatz gemäß Anspruch 23, wobei der getaktete Sperrwandler über einen oder mehrere Synchronausgangs- oder Sekundärgleichrichter verfügt.

25. Batteriesatz gemäß Anspruch 23 oder Anspruch 24, wobei der getaktete Sperrwandler über eine oder mehrere Ausgangs- oder Sekundärgleichrichterdioden verfügt.

26. Batteriesatz gemäß einem der vorherigen Ansprüche, wobei ein getakteter magnetischer oder kapazitiver Wandler dazu konfiguriert sein kann, innerhalb des Batteriesatzes aktiv Energie von starken Zellen zu schwachen Zellen zu übertragen.

27. Batteriesatz gemäß einem der vorherigen Ansprüche, wobei das Batteriemanagementsystem über eine Einrichtung zur Messung des Selbstentladestroms verfügt.

28. Batteriesatz gemäß Anspruch 27, wobei die Einrichtung zur Messung der Selbstentladung einen stromgesteuerten Oszillator umfasst, der mit einer Batterie gekoppelt werden kann, wenn sich die Batterie im Schlafmodus befindet, wobei der stromgesteuerte Oszillator einen Temperaturkoeffizienten hat, der dem Temperaturkoeffizienten der Batterie entspricht.

29. Batteriesatz gemäß einem der vorherigen Ansprüche, wobei das Batteriemanagementsystem über eine Einrichtung zur Deaktivierung der Batterie während des Transports verfügt, wobei diese Einrichtung als eine Anweisung von der programmierbaren Logik bereitgestellt wird.

30. Batteriesatz gemäß einem der vorherigen Ansprüche, wobei das Batteriemanagementsystem in eine anwendungsspezifische integrierte Schaltung integriert ist.

31. Batteriesatz gemäß einem der vorherigen Ansprüche, wobei das Batteriemanagementsystem in eine separate Platine integriert ist.

## Revendications

1. Un bloc-batterie contenant:
une batterie; et
un système de gestion de batterie comportant un ou plusieurs moyen(s) de surveillance de batterie et une logique programmable :
où la logique programmable est connectée au ou aux moyen(s) de surveillance de batterie pour modifier son fonctionnement de batterie et rendre compte du statut de batterie ; et le système de gestion de batterie est intégré dans le bloc-batterie, avec la batterie ;
**caractérise en ce que** le moyen de surveillance de batterie comporte un moyen de commande d'équilibrage de cellules actives associé à chaque cellule de batterie et utilisable pour permettre le transfert d'énergie de cellules fortes à cellules faibles durant à la fois les cycles de chargement et de déchargement, et où le moyen de commande d'équilibrage de cellules actives est utilisable comme chargeur à part entière.

2. Un bloc-batterie tel que revendique dans la revendication 1, où le moyen de surveillance de batterie rend compte du statut de batterie par le biais d'un bus de communication à un hôte externe.

3. Un bloc-batterie tel que revendiqué dans la revendication 1 ou 2, où le moyen de surveillance de batterie est doté d'un moyen d'acquisition de données pour enregistrer la performance de batterie.

4. Un bloc-batterie tel que revendiqué dans n'importe quelle revendication précédente, où la logique programmable est configurée pour analyser les données reçues du ou des moyen(s) de surveillance de batterie et pour méditer le fonctionnement de la batterie en réponse auxdites données.

5. Un bloc-batterie tel que revendiqué dans la revendication 3, où le moyen d'acquisition de données est placé d'un bout à l'autre de chaque cellule de la batterie pour collecter des données à partir de ladite cellule.

6. Un bloc-batterie tel que revendiqué dans la revendication 3 ou la revendication 5, où le moyen d'acquisition de données est configuré pour collecter des données à partir d'une pluralité du cellules.

7. Un bloc-batterie tel que revendiqué dans n'importe quelle revendication précédente, où la logique programmable est configurée pour analyser des données physiques.

8. Un bloc-batterie tel que revendiqué dans n'importe quelle revendication précédente, où la logique programmable est configurée pour analyser des données physiques liées à l'effet de la température sur la capacité de batterie et/ou l'effet de la température sur le courant d'autodécharge de batterie.

9. Un bloc-batterie tel que revendiqué dans n'importe quelle revendication précédente, où la logique programmable est configurée pour dériver l'état réel de charge à n'importe quelle température de fonctionnement.

10. Un bloc-batterie tel que revendiqué dans n'importe quelle revendication précédente, où la logique programmable contient une ou plusieurs table(s) de conversion et/ou un ou plusieurs algorithme(s)

11. Un bloc-batterie tel que revendiqué dans n'importe quelle revendication précédente, où la logique programmable comporte un microprocesseur numérique et une mémoire numérique

12. Un bloc-batterie tel que revendiqué dans n'importe quelle revendication précédente, où la logique programmable comporte un moyen de communication numérique avec des systèmes interne(s) et externe(s) et la capacité de rendre compte du statut de batterie et de fournir une commande externe d'une batterie

13. Un bloc-batterie tel que revendiqué dans n'importe quelle revendication précédente, où la logique programmable est intégrée dans le système de gestion de batterie.

14. Un bloc-batterie tel que revendiqué dans n'importe quelle revendication précédente, où le moyen de surveillance de batterie comporte un moyen de mesure d'état de charge.

15. Un bloc-batterie tel que revendiqué dans n'importe quelle revendication précédente, où le moyen de surveillance de batterie comporte un moyen de mesure d'état de santé.

16. Un bloc-batterie tel que revendiqué dans n'importe quelle revendication précédente, où le moyen de surveillance de batterie comporte un moyen de protection de batterie.

17. Un bloc-batterie tel que revendiqué dans n'importe quelle revendication précédente, où le moyen de protection de batterie comporte un moyen de commutation pour commander la circulation du courant en provenance d'une source d'alimentation.

18. Un bloc-batterie tel que revendiqué dans n'importe quelle revendication précédente, où le moyen de surveillance de batterie comporte un moyen formant témoin de charge.

19. Un bloc-batterie tel que revendiqué dans la revendication 1, où la commande d'équilibrage de cellules actives comporte un convertisseur à découpage, qui peut être assujetti à une source d'énergie primaire et capable de déplacer de l'énergie de la source d'énergie primaire vers une ou plusieurs cellule(s) en fonction des besoins d'énergie respectifs des cellules.

20. Un bloc-batterie tel que revendiqué dans n'importe quelle revendication précédente, où la logique programmable est adaptée pour faire fonctionner le moyen de commande de température.

21. Un bloc-batterie tel que revendiqué dans la revendication 20, où le moyen de commande de température comporte un moyen de chauffage pour chauffer les cellules.

22. Un bloc-batterie tel que revendiqué dans la revendication 19, où le moyen d'équilibrage de cellules actives fonctionne comme système de suppression de sulfatation quand il est utilisé dans un empilage de batteries Pb (au plomb).

23. Un bloc-batterie tel que revendiqué dans la revendication 19, où une topologie à transfert indirect peut être utilisée comme convertisseur à découpage.

24. Un bloc-batterie tel que revendiqué dans la revendication 23, où le convertisseur à découpage à transfert indirect est doté d'un ou plusieurs redresseur(s) secondaire(s) ou de débit synchrone(s).

25. Un bloc-batterie tel que revendiqué dans la revendication 23 ou la revendication 24, où le convertisseur à découpage à transfert indirect est doté d'une ou plusieurs diode(s) de redresseur secondaire ou de débit.

26. Un bloc-batterie tel que revendiqué dans n'importe quelle revendication précédente, où un convertisseur capacitatif ou magnétique commuté peut être configuré pour transférer de l'énergie activement des cellules fortes aux cellules faibles à l'intérieur du bloe-butterie.

27. Un bloc-batterie tel que revendiqué dans n'importe quelle revendication précédente, où le système de gestion de batterie est doté d'un moyen de mesure de courant d'autodécharge.

28. Un bloc-batterie tel que revendiqué dans la revendication 27, où le moyen de mesure d'autodécharge comporte un oscillateur de courant qui peut être couplé à une batterie quand la batterie est en mode sommeil, l'oscillateur de courant ayant un coefficient de température qui correspond au coefficient de température de la batterie.

29. Un bloc-batterie tel que revendiqué dans n'importe quelle revendication précédente, où le système de gestion de batterie est doté d'un moyen pour désactiver la batterie pendant le transit, ledit moyen étant fourni comme une instruction de la logique programmable.

30. Un bloc-batterie tel que revendiqué dans n'importe quelle revendication précédente, où le système de gestion de batterie est incorporé dans un circuit intégré à application spécifique.

31. Un bloc-batterie tel que revendiqué dans n'importe laquelle des revendications précédentes, où le système de gestion de batterie est incorporé dans une carte de circuit imprimé discret.
